# EUROPEAN PATENT APPLICATION

(11) **EP 2 889 910 A1**
(43) Date of publication of application: **01.07.2015**
(21) Application number: 14178100.5
(22) Date of filing: 23.07.2014
(51) Int. Cl.: H01L 27/15, H01L 23/482, H01L 33/62

(54) **Light-emitting diode element**

(30) Priority: 26.12.2013 TW 102148365
(71) Applicant: Lextar Electronics Corp., 30075 Hsinchu (TW)
(72) Inventor: Fong, Wen-Fei, 300 Hsinchu City (TW); Yu, Wei-Chang, 807 Kaohsiung City (TW)
(74) Representative: Fuchs Patentanwälte Partnerschaft mbB

(57) **Abstract**

A light-emitting diode element is provided. N light-emitting diode chips are arranged on a substrate. Each light-emitting diode chip includes a first-type semiconductor layer, an active layer, a second-type semiconductor layer, a first electrode, and a second electrode. The first-type semiconductor layer is disposed on the substrate. The active layer is disposed on the first-type semiconductor layer to bare a surface of a portion of the first-type semiconductor layer. The second-type semiconductor layer is disposed on the active layer. The first and second electrode are disposed on the first-type and second-type semiconductor layers respectively. The second electrode is close to a side of the second-type semiconductor layer which is opposite side of the first-type semiconductor layer. First and second connection lines connect the first electrode of an i-th light-emitting diode chip and the second electrode of an (i+1)-th light-emitting diode chip among the light-emitting diode chips.

## Description

### CROSS REFERENCE TO RELATED APPLICATIONS

This Application claims priority of Taiwan Patent Application No. 102148365, filed on Dec. 26, 2013, the entirety of which is incorporated by reference herein.

### BACKGROUND OF THE INVENTION

### Field of the Invention

The invention relates to light-emitting diode element, and more particularly to a connection structure between light-emitting diode chips of a light-emitting diode element.

### Description of the Related Art

Generally, one light-emitting diode element comprises a plurality of light-emitting diode chips. In conventional light-emitting diode elements, two adjacent light-emitting diode chips on the same column are coupled in series through a single one channel electrode. However, in the design based on the single one channel electrode, when the single one channel electrode between one set of two adjacent light-emitting diode chips on one column is broken off, the other light-emitting diode chips on the same column are unable to operate normally. Moreover, when the single one channel electrode between one set of two adjacent light-emitting diode chips on one column has large equivalent resistor, the voltage on the channel electrode, thus, has higher voltage-shifting magnitude.

### BRIEF SUMMARY OF THE INVENTION

Thus, it is desirable to provide a light-emitting diode element. Connection structure between light-emitting diode chips in the light-emitting diode element is configured to avoid the above breaking-off and the higher voltage of the channel electrodes of the prior arts.

An exemplary embodiment of a light-emitting diode element comprises a substrate, N light-emitting diode chips, at least one first connection line, and at least one second connection line. N light-emitting diode chips are arranged on the substrate. Each light-emitting diode chip comprises a first-type semiconductor layer, an active layer, a second-type semiconductor layer, a first electrode, and a second electrode. The first-type semiconductor layer is disposed on the substrate. The active layer is disposed on the first-type semiconductor layer to bare a surface of a portion of the first-type semiconductor layer. The second-type semiconductor layer is disposed on the active layer. The first electrode is disposed on the first-type semiconductor layer. The second electrode is disposed on the second-type semiconductor layer. The second electrode is close to a side of the second-type semiconductor layer which is opposite side of the first-type semiconductor layer. The least one first connection line and the least one second connection line connect the first electrode of an i-th light-emitting diode chip and the second electrode of an (i+1)-th light-emitting diode chip among the light-emitting diode chips, The i-th light-emitting diode chip and the (i+1)-th light-emitting diode chip are adjacent to each other. Both of i and N are natural numbers, N ≧ 2, and 1 ≦i≦N-1.

A detailed description is given in the following embodiments with reference to the accompanying drawings.

### BRIEF DESCRIPTION OF THE DRAWINGS

The invention can be more fully understood by reading the subsequent detailed description and examples with references made to the accompanying drawings, wherein:
FIG. 1 is a vertical view of light-emitting diode chips coupled in series on the same column according to an exemplary embodiment;
FIG. 2 shows an equivalent circuit of light-emitting diode chips coupled in series on the same column according to an exemplary embodiment;
FIG. 3 is a cross-sectional view of light-emitting diode chips coupled in series on the same column according to an exemplary embodiment;
FIG. 4 is a vertical view of light-emitting diode chips coupled in series on the same column according to another exemplary embodiment; and
FIG. 5 shows an exemplary embodiment of a light-emitting diode element.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

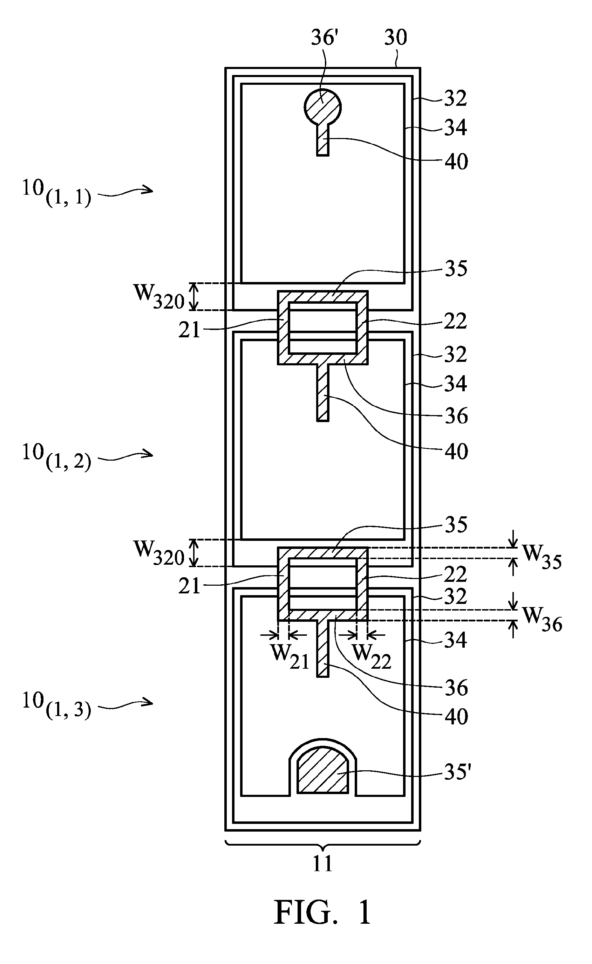

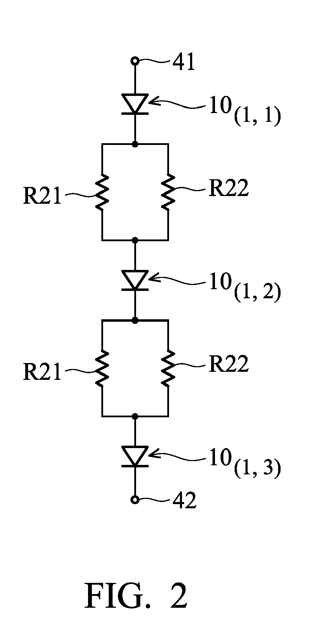

FIG. 1 is a vertical view of light-emitting diode chips coupled in series on the same column (column 11). Referring to FIG. 1, in an embodiment, connection between a first electrode 35 of a light-emitting diode chip 10_{(1,1)}, a second electrode 36 of a light-emitting diode chip 10_{(1,2)} following the light-emitting diode chip 10_{(1,1)}, and connection lines 21 and 22 forms configuration of a loop in the vertical view. Connection between a first electrode 35 of a light-emitting diode chip 10_{(1,2)}, a second electrode 36 of a light-emitting diode chip 10_{(1,3)} following the light-emitting diode chip 10_{(1,2)}, and connection lines 21 and 22 also forms configuration of a loop in the vertical view. In the embodiment of FIG. 1, the second diode 36 of each light-emitting diode chip comprises a finger portion 40 which extends toward the direction of the respective first electrode 35. FIG. 2 shows an equivalent circuit of the light-emitting diode chip 10_{(1,1)}∼10_{(1,3)} on the column 11. In FIG. 2, a resistor R21 represents equivalent resistor of the connection line 21, and a resistor R22 represents equivalent resistor of the connection line 22.

Referring to FIG. 2, a terminal 41 is coupled to the second electrode 36 of the light-emitting diode chip 10_{(1,1)}, and a terminal is coupled to the first electrode 25 of the light-emitting diode chip 10_{(1,3)}. The terminal 41 is coupled to a positive electrode, while the terminal 42 is coupled to negative electrode.

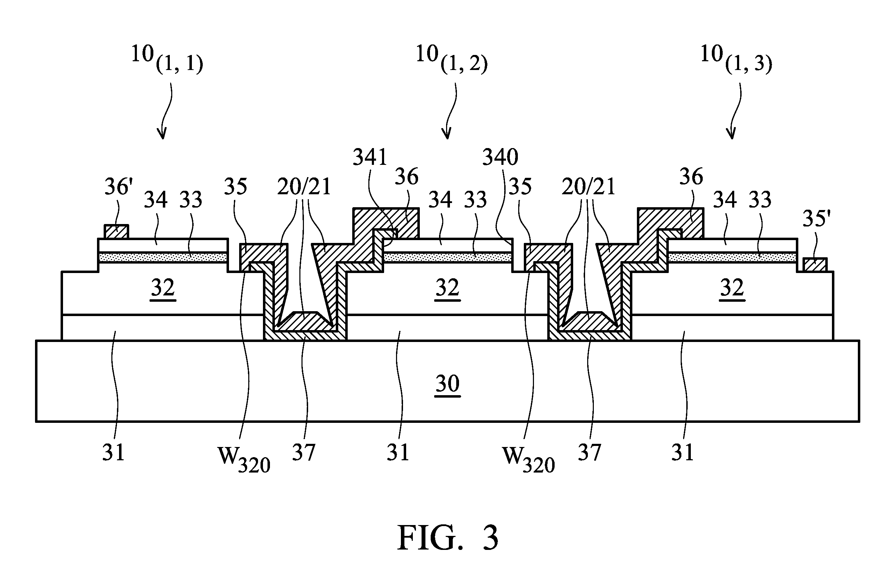

FIG. 3 is a cross-sectional view of light-emitting diode chips coupled in series on the same column. Referring to FIG. 3, each light-emitting diode chips 10_{(1,1)}∼ 0_{(1,3)} comprises a buffer layer 31, an N-type semiconductor layer 32, an active layer 33, a P-type semiconductor layer 34, a first electrode 35, and a second electrode 36. Each buffer layer 31 is disposed on a substrate 30. The N-type semiconductor layer 32 is disposed on the corresponding buffer layer 31. The active layer 33 is disposed on a portion of the corresponding N-type semiconductor layer 32, such that another portion of the corresponding N-type semiconductor layer 32 is bared. The first electrode 35 is disposed on the bared portion of the corresponding N-type semiconductor layer 32. The P-type semiconductor layer 34 has two sides 340 and 341. One side 340 is adjacent to the corresponding first electrode 35, and the other side 341 is opposite side of the corresponding first electrode 35. The second electrode 36 is disposed on the P-type semiconductor layer 34 and close to the side 341.

According to the above description, the light-emitting diode chip 10_{(1,2)} is coupled to the previous light-emitting diode chip and the next light-emitting diode chip through the connection lines 21 and 22. Since the light-emitting diode chips 10_{(1,1)} and 10_{(1,3)} are the first one and the last one among the light-emitting diode chips one the column 11, each of the light-emitting diode chips 10_{(1,1)} and 10_{(1,3)} is coupled to the previous light-emitting diode chip or the next light-emitting diode chip. In the embodiment of FIG. 1, the second electrode 36' of the light-emitting diode chip 10_{(1,1)} is coupled to an external positive electrode instead of another light-emitting diode chip. The configuration formed by the second electrode 36' of the light-emitting diode chip 10_{(1,1)} and the external positive electrode is different from the other light-emitting diode chips 10_{(1,2)} and 10_{(1,3)}. The first electrode 35' of the light-emitting diode chip 10_{(1,3)} is coupled to an external negative electrode instead of another light-emitting diode chip. The configuration formed by the first electrode 35' of the light-emitting diode chip 10_{(1,3)} and the external negative electrode is different from the other light-emitting diode chips 10_{(1,1)} and 10_{(1,2)}.

In an embodiment, the width W21 of the connection line 21 and the width W22 of the connection line 22 are equal to the line width W35 of the first electrode 35 or the line width W36 of the second electrode 36. As shown in the embodiment of FIG. 1, both of the width W21 of the connection line 21 and the width W22 of the connection line 22 are equal to the line width W35 of the first electrode 35 or the line width W36 of the second electrode 36, and the line width W35 of the first electrode 35 is equal to the line width W36 of the second electrode 36. Thus, the width W21 of the connection line 21, the width W22 of the connection line 22, the line width W35 of the first electrode 35, and the line width W36 of the second electrode 36 are equal. In another embodiment, the line width W35 of the first electrode 35 is not equal to the line width W36 of the second electrode 36.

In order to prevent the connection lines 21 and 22 from being broken up or becoming greater, the width W21 of the connection 21 and the width W22 of the connection 22 are larger than the line width W35 of the first electrode 35 or the line width W36 of the second electrode 36. In an embodiment, both of the width W21 of the connection line 21 and the width W22 of the connection line 22 are larger than the line width W35 of the first electrode 35 or the line width W36 of the second electrode 36, and the line width W35 of the first electrode 35 is equal to the line width W36 of the second electrode 36. Thus, both of the width W21 of the connection line 21 and the width W22 of the connection line 22 are larger than the line width W35 of the first electrode 35 and the line width W36 of the second electrode 36. In another embodiment, the line width W35 of the first electrode 35 is not equal to the line width W36 of the second electrode 36.

According to FIG. 3 showing the structure of each light-emitting diode chip, due to the disposition of the active layer 33, a portion of the N-type semiconductor layer 32 is bared. Referring to FIGs. 1 and 3, in an embodiment, the surface width W320 of the bared portion of the N-type semiconductor 32 is less than 15um. In another embodiment, the surface width of the bared portion of the N-type semiconductor 32, which is close to the second electrode 36, is less than 15um.

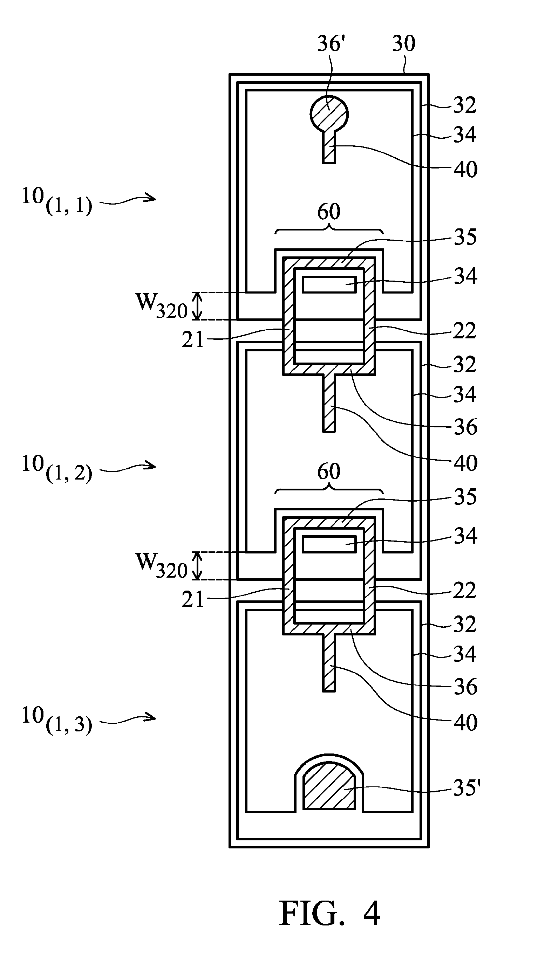

In the embodiment of FIG. 1, the first electrode 35 is disposed between the edge of the N-type semiconductor layer 32 and the edge of the P-type semiconductor layer 34. In other embodiments, the N-type semiconductor layer 32 is further bared along a groove 60. In detail, the groove 60 is formed by etching the active layer 33 and the P-type semiconductor layer 34 which are disposed on the N-type semiconductor layer 32. The first electrode 35 is disposed on the groove 60, as shown in FIG. 4.

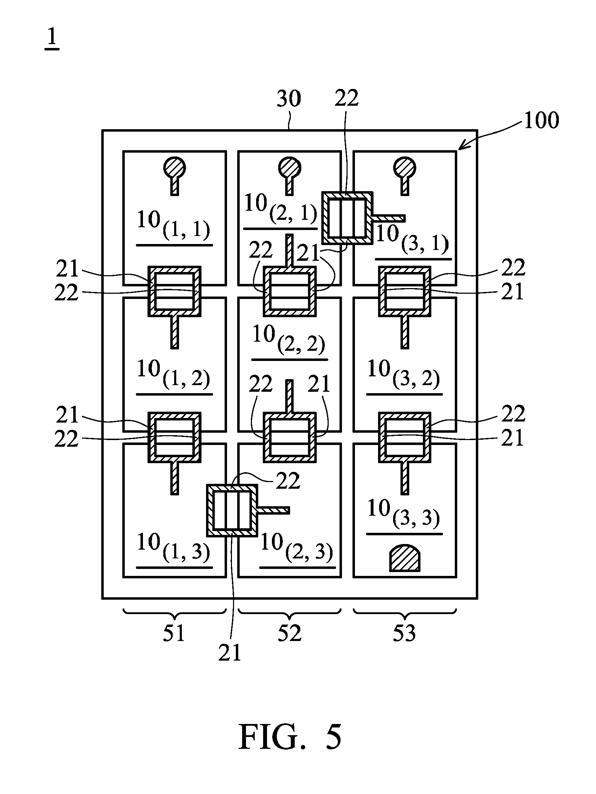

FIG. 5 shows an exemplary embodiment of a light-emitting diode element 1. The light-emitting diode element 1 comprises a plurality of light-emitting diode chips (that is N light-emitting diode chips), wherein N is a natural number and N≧2. In these light-emitting diode chips 10_{(1,1)}∼10_{(P,Q)} are disposed on the substrate 30 and arranged in an array 100 of P columns and N rows (that is P (columns) x N (rows) array 100), wherein each of P and N is a natural number which is larger than or equal to 2, and the product of P and N is equal to N (P × Q = N). As shown in FIG. 5, the light-emitting diode chip which is disposed in the position on the location of the first column and the first row of the array 100 serves as the first light-emitting diode chip 10_{(1,1)} of the light-emitting diode element 1; the light-emitting diode chip which is disposed on the location of the position on the first column and the second row of the array 100 serves as the second light-emitting diode chip 10_{(1,2)} of the light-emitting diode element 1; the light-emitting diode chip which is disposed in the position on the location of the P-th column and the Q-th row of the array 100 serves as the N-th light-emitting diode chip 10_{(P,Q)} of the light-emitting diode element 1. In the following, a 3 (columns) x 3 (rows) array 100 (that that P = 3, and Q = 3) is given as an example to illustrate the light-emitting diode element 1.

Referring to FIG. 5, the light-emitting diode chips disposed in the same column are coupled together, and the last light-emitting diode chip on the same column is coupled to the first light-emitting diode chip on the adjacent column. In detail, the first to third light-emitting diode chips 10_{(1,1)}, 10_{(1,2)}, and 10_{(1,3)} of the light-emitting diode element 1 are disposed on the same column 51 and coupled together through the connection lines 21 and 22; the fourth to sixth light-emitting diode chips 10_{(2,1)}, 10_{(2,2)}, and 10_{(2,3)} of the light-emitting diode element 1 are disposed on the same column 52 and coupled together through the connection lines 21 and 22; the seventh to ninth light-emitting diode chips 10_{(3,1)}, 10_{(3,2)}, and 10_{(3,3)} of the light-emitting diode element 1 are disposed on the same column 53 and coupled together through the connection lines 21 and 22. The light-emitting diode chip 10_{(1,3)} on the first column 51 is coupled to the light-emitting diode chip 10_{(2,3)} on the first column 52 in series, and the arrangement direction the light-emitting diode chips 10_{(2,1)}, 10_{(2,2)}, and 10_{(2,3)} on the second column 52 is inverse to that on the first column 51. Similarly, the light-emitting diode chip 10_{(2,1)} on the second column 52 is coupled to the light-emitting diode chip 10_{(3,1)} on the third column 53 in series, and the arrangement direction the light-emitting diode chips 10_{(3,1)}, 10_{(3,2)}, and 10_{(3,3)} on the second column 53 is inverse to that on the second column 52. Thus, the light-emitting diode chips on the three columns are coupled in series, and the two light-emitting diode chips which are disposed at the two terminals on the series line are coupled to external electrodes respectively. The structure and connection of the light-emitting diode chips on one column are the same as these on the other columns, and the arrangement directions of the two adjacent columns are inverse. In the following, the light-emitting diode chips 10_{(1,1)}, 10_{(1,2)}, and 10_{(1,3)} disposed on the column 51 are given as example to illustrate the connection between the light-emitting diode chips on the same column by referring to FIG. 3.

As shown in FIG. 3, for the adjacent light-emitting diode chips 10_{(1,1)} (the first light-emitting diode chip) and 10_{(1,1)} (the first light-emitting diode chip), each of the connection lines 21 and 22 are coupled to the first electrode 35 of the light-emitting diode chip 10_{(1,1)} and the second electrode 36 of the next light-emitting diode chip 10_{(1,2)}. For, the adjacent light-emitting diode chips 10_{(1,2)} (the second light-emitting diode chip) and 10_{(1,3)} (the third light-emitting diode chip), each of the connection lines 21 and 22 are coupled to the first electrode 35 of the light-emitting diode chip 10_{(1,2)} and the second electrode 36 of the next light-emitting diode chip 10_{(1,3)}. Since FIG. 3 is a cross-sectional view of light-emitting diode chips 10_{(1,1)}∼10_{(1,3)}, the connection lines 21 and 22 are represented by a connection line structure. Referring to FIG. 3, the light-emitting diode element 1 further comprises isolation layers 37 which are formed under the connection lines 21 and 22 to isolate the areas expect the areas where the connection lines 21 and 22 touch the first electrodes 35 and the second electrodes 36. In the embodiment, since the light-emitting diode chips 10_{(1,1)} is the first light-emitting diode chip on the column 51, there is no light-emitting diode chip followed by the light-emitting diode chips 10_{(1,1)}. According to the disposition of the light-emitting diode chips 10_{(1,1)}, the second electrode 36' can be coupled to an external positive electrode. Moreover, since the light-emitting diode chips 10_{(1,3)} is the last light-emitting diode chip on the column 51, there is no light-emitting diode chip following the light-emitting diode chips 10_{(1,3)}. In this condition, the first electrode 35' can be coupled to an external negative electrode.

The present invention provides the structure of the light-emitting diode chips and connection between two adjacent light-emitting diode chips. According to the above embodiment, one set of the connection lines are used to couple the first electrode 35 of the i-th light-emitting diode chip and the second electrode 36 of the (i+1)-th light-emitting diode chip which are disposed on the same column, wherein i is a natural number and 1 ≦ i ≦N-1. Accordingly, the connection between two adjacent light-emitting diode chips is implemented by two connection lines (that is two channels). When one of the two connection lines is broken up, the driving current still flows through the connection line which is not broken up, such that the other light-emitting diode chips on the same column are not affected by the broken-up situation, and they can operate normally. Moreover, the equivalent circuit of the two connection lines between the two adjacent light-emitting diode chips is two resistors which are coupled in parallel. When the equivalent resistor of one connection line become larger, the voltage-shifting magnitude of the two connection lines is lower.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A light-emitting diode element (1) comprising:
a substrate (30);
N light-emitting diode chips (10_{(1,1)}∼10_{(3,3)}) arranged on the substrate (30), wherein each light-emitting diode chip comprises:
a first-type semiconductor layer (32) disposed on the substrate;
an active layer (33) disposed on the first-type semiconductor layer (32) to bare a surface of a portion of the first-type semiconductor layer (32);
a second-type semiconductor layer (34) disposed on the active layer (33);
a first electrode (35) disposed on the first-type semiconductor layer (32); and
a second electrode (36) disposed on the second-type semiconductor layer (34) and close to a side (341) of the second-type semiconductor layer (34) which is opposite side of the first-type semiconductor layer (34); and
at least one first connection line (21) and at least one second connection line (22) connecting the first electrode (35) of an i-th light-emitting diode chip (10_{(1,2)}) and the second electrode (36) of an (i+1)-th light-emitting diode chip (10_{(1,3)}) among the light-emitting diode chips (10_{(1,1)}∼10_{(3,3)}),
wherein the i-th light-emitting diode chip (10_{(1,2)}) and the (i+1)-th light-emitting diode chip (10_{(1,3)}) are adjacent to each other, both of i and N are natural numbers, N ≧ 2, and 1 ≦ i ≦ N-1.

2. The light-emitting diode element as claimed in claim 1, wherein the first electrode (35) of the i-th light-emitting diode chip (10_{(1,2)}), the second diode (36) of the (i+1)-th light-emitting diode chip (10_{(1,3)}), and the first and second connection lines (21,22) connecting the i-th and (i+1)-the light-emitting diode chips (10_{(1,2)}, 10_{(1,3)}) forms configuration of a loop in a vertical view.

3. The light-emitting diode element as claimed in claim 2, wherein each of the second electrodes (36) further comprises a finger portion (40) which extends toward a direction of the corresponding first electrode (35).

4. The light-emitting diode element as claimed in claim 1, wherein a width (W21) of the first connection line (21) and a width (W22) of the second connection line (22) are equal or larger than a width (W35, W36) of the first or second electrode (35,36) which the first and second connection lines (21,22) connect to.

5. The light-emitting diode element as claimed in claim 1, wherein a surface width of the bared portion of the first electrode (35) is less than 15 um.

6. The light-emitting diode element as claimed in claim 1, wherein the light-emitting diode chips (10_{(1,1)}∼10_{(3,3)}) are arranged in an array of P columns (51-53) and N rows, a first light-emitting diode chip (10_{(1,1)}) among the light-emitting diode chips is disposed on a location of a first column (51) and a first row, and a N-th light-emitting diode chip (10_{(3,3)}) among the light-emitting diode chips (10_{(1,1)}∼10_{(3,3)}) is disposed on a location of a P-th column (51-53) and a Q-th row, P and N are natural numbers which are larger than or equal to 2, and a product of P and N is equal to N (P × Q = N).

7. The light-emitting diode element as claimed in one of claim 1, wherein the first-type semiconductor layer (32) is implemented by an N-type semiconductor layer, and the second-type semiconductor layer (34) is implemented by a P-type semiconductor layer.

8. The light-emitting diode element as claimed in claim 7, further comprising:
an isolation layer (37) formed under the first and second connection lines (21,22) to isolate areas except areas where the first and second connection lines (21,22) touch the first and second electrodes (35,36).
